# EUROPÄISCHE PATENTSCHRIFT

(11) **EP 3 176 822 B1**
(45) Veröffentlichungstag und Bekanntmachung des Hinweises auf die Patenterteilung: **15.09.2021**
(21) Anmeldenummer: 15197956.4
(22) Anmeldetag: 04.12.2015
(51) Int. Cl.: H01L 25/07, H01L 25/11, H02M 7/00

(54) **ELEKTRISCH UND THERMISCH EFFIZIENTE LEISTUNGSBRÜCKE**
ELECTRICALLY AND THERMALLY EFFICIENT POWER BRIDGE
PONT DE PUISSANCE EFFICACE ELECTRIQUEMENT ET THERMIQUEMENT

(43) Veröffentlichungstag der Anmeldung: 07.06.2017
(73) Patentinhaber: Robert Bosch GmbH, 70442 Stuttgart (DE)
(72) Erfinder: Scholz, Reinhard, 64711 Erbach (DE)

(56) Entgegenhaltungen:
- EP-A1- 2 546 874
- WO-A1-2013/005385
- WO-A1-2015/162856
- DE-A1-102013 102 542
- JP-A- 2005 303 018
- JP-A- 2006 134 990
- JP-A- 2008 042 089
- US-A- 5 671 134
- US-A1- 2011 057 713

## Beschreibung

### Technisches Gebiet

Die Erfindung betrifft eine Anordnung zur Realisierung eines Leistungsbauteils zur Bereitstellung eines Starkstromes, insbesondere eines Starkstromes, wie er bei industriellen Prozessen, leistungsfähigen Maschinen, oder beim Widerstandsschweißen benötigt wird.

### Stand der Technik

US 2011/057713 A1 zeigt ein Leistungsmodul, bei welchem eine erste Halbleitervorrichtung, die auf einem ersten Substrat angeordnet ist, und eine zweite Halbleitervorrichtung, die auf einem zweiten Substrat angeordnet ist, an symmetrischen Positionen angeordnet sind, zwischen welchen ein drittes Substrat angeordnet ist. Der Eingang des Leistungsmoduls ist zwischen dem ersten Substrat und dem mittleren dritten Substrat gebildet.

JP 2006-134990 A und JP 2005-303018 A zeigen jeweils ein Halbleitermodul, bei dem auf einer äußeren Metallplatte 13c eine Leitungsbahn für einen Emitteranschluss eines ersten IGBTs 11Na und eine Leitungsbahn für den Steueranschluss 14 des ersten IGBTs 11Na ausgebildet ist. Zudem ist auf einer mittleren Metallplatte 13b eine Leitungsbahn für einen Emitteranschluss eines zweiten IGBTs 11Pa und eine Leitungsbahn für den Steueranschluss 14 des IGBTs 11Pa ausgebildet. Somit haben die Steueranschlüsse der IGBTs jeweils Kontakt zu den Platten 13b, 13c des Halbleitermoduls. Außerdem sind keine Bauteilträger gezeigt, die zur Wärmeabfuhr verwendet werden.

Das Patent DE 196 30 173 C2 offenbart ein Leistungshalbleitermodul zur direkten Montage auf einem Kühlkörper, bestehend aus einem Gehäuse und einem elektrisch isolierenden Substrat, welches seinerseits aus einem Isolierstoffkörper mit einer Mehrzahl darauf befindlicher gegeneinander isolierter metallischer Verbindungsbahnen und darauf befindlichen und mit diesen Verbindungsbahnen schaltungsgerecht verbundenen Leistungshalbleiterbauelementen besteht. Die externe elektrische Verbindung zu einer außerhalb des Gehäuses angeordneten Leitplatte erfolgt mittels zumindest teilweise federnd gestalteter Anschlussleiter.

Die Verwendung solcher Federanschlüsse ist nachteilig, da hierbei Verluste durch ungenügenden Kontaktdruck entstehen. Um dies zu vermeiden werden sehr hohe mechanische Spannkräfte erforderlich. Dies erfordert wiederum entsprechend aufwändige mechanische Spannvorrichtungen, außerdem präzise und saubere Kontaktflächen. Zusätzlich muss das verwendete Halbleitermaterial auch für einen solchen Druck ausgelegt und damit relativ dickwandig sein, was zwangsläufig wiederum höhere Verluste mit sich bringen kann, weil dann die Wärmeabfuhr vom Halbleiter nicht mehr so effizient wie bei einem dünneren Material realisierbar ist.

Es ist daher eine Lösung wünschenswert, welche ohne Spannvorrichtungen auskommt und eine geringe Verlustleistung im Betrieb aufweist. Zusätzlich wünschenswert ist, dass mit der Lösung ein thermisch verlustoptimierter und möglichst kompakter Aufbau mindestens einer Halbbrückeenschaltung realisierbar ist und die Herstellung der Halbbrücke in möglichst wenigen Fertigungsschritten erfolgen kann.

### Offenbarung der Erfindung

Erfindungsgemäß werden die Lösungen gemäß dem unabhängigen Patentanspruch vorgeschlagen. Ausgangspunkt der Erfindung sind Schaltmittel in Form von Leistungshalbleitern mit einem Stromeingang, einem Stromausgang und einem Steueranschluss zur Steuerung eines Starkstromes zwischen Stromeingang und Stromausgang während des Betriebs des Halbleiters.

Unter einem Starkstrom werden Ströme verstanden, wie sie beispielsweise beim Widerstandsschweißen, zum Antrieb von Servomotoren oder zum Betrieb von leistungsfähigen Maschinen oder zum Betrieb von Fahrzeugen verwendet werden. Es handelt sich in der Regel um Ströme im einstelligen oder zweistelligen Kiloampere-Bereich, vorzugsweise aus Dreiphasen-Netzen. Es kommen vor allem Anwendungen in Frage, bei denen eine Zwischenkreisspannung bereitgestellt werden muss oder eine Gleichrichtung des Stromes erforderlich wird, beispielsweise im Rahmen eines Wechselrichtens oder eines Umrichtens zum Zwecke des Betreibens von elektrischen Motoren, auch elektrischen Fahrzeugmotoren oder Hybridfahrzeugen.

Ein erster Anschluss der Leistungshalbleiter ist erfindungsgemäß mit einer elektrisch leitfähigen Eingangsleitplatte und ein zweiter Anschluss der Leistungshalbleiter ist mit einer elektrisch leitfähigen Ausgangsleitplatte verbunden. Erfindungsgemäß sind die Ebenen der Platten im Wesentlichen parallel und bündig zueinander ausgerichtet, so dass sich eine möglichst kompakte Bauform ergibt, welche den genringst erforderlichen Bauraum in Anspruch nimmt. Als Verbindungsmittel dienen Fügemittel, die elektrisch leitfähig sind und welche stoffschlüssige Verbindungen ermöglichen. Als Fügeprozess kommt beispielsweise Löten oder Sintern, ggf. auch Schweißen in Frage. Der Steueranschluss ist derart zwischen der Eingangsleitplatte und der Ausgangsplatte angeordnet, dass dieser keinen elektrischen Kontakt zu den Platten hat und trotzdem zur Ansteuerung der Leistungshalbleiter noch zwischen den Platten zugänglich bleibt. Als Plattenmaterial kommt beispielsweise Kupfer oder Molybdän oder Aluminium in Frage. Die Platten können einteilig oder auch mehrteilig ausgebildet sein.

Bei dem Leistungshalbleiter kann es sich um einen stromgesteuerten oder spannungsgesteuerten Halbleiter handeln, wie beispielsweise einen Bipolar-Transistor, einen IGBT, einen FET oder einen MOSFET oder Varianten davon oder dergleichen. Die Steuerung kann beispielsweise mittels einer Gate-Source-Spannung erfolgen. Sinngemäß erfolgt die Ansteuerung von Halbleitern anderer Bauart dann entsprechend ihrer Datenblätter.

Beide Schaltmittel sind mittels der mittleren Ausgangsleitplatte derart miteinander in Serie geschaltet, dass ein Ausgang der Halbbrückenschaltung mittels der Ausgangsleitplatte realisiert ist. Das erste Schaltmittel ist mit seinem Eingang oder Ausgang mit der ersten Eingangsleitplatte und das zweite Schaltmittel ist mit seinem Ausgang oder Eingang mit der zweiten Eingangsleitplatte verbunden. Der Begriff Schaltmittel meint nicht zwangsläufig ein einziges Leistungsbauteil, er umfasst insbesondere auch mehrere parallel zueinander verschaltete Bauteile, welche wie ein einziges Bauteil zusammenwirken können.

Vorteilhafte Ausgestaltungen sind Gegenstand der Unteransprüche sowie der nachfolgenden Beschreibung.

### Vorteile der Erfindung

Dadurch, dass sich beide Platten parallel gegenüberliegen, ist eine sehr kompakte Anordnung realisiert, welche sich bauraumeffizient in einer speziell dafür vorgesehenen Aufnahmevorrichtung anordnen lässt. Über die mittlere Ausgangsleitplatte ist der Ausgang der Halbbrückenschaltung zwischen beiden Eingangsleitplatten angeordnet, so dass sich das Ausgangssignal der Halbbrückenschaltung ebenso bauraumeffizient von der Anordnung abgreifen lässt, wie sich das Eingangssignal einspeisen lässt.

Aufgrund des erfindungsgemäß optimierten Aufbaus in Sandwichbauweise kann der Leistungsschalter in den verschiedensten Applikationen mit Halbbrückenschaltung eingesetzt werden, bei denen ein thermisch und elektrisch effizienter Betrieb gewünscht ist, beispielsweise bei batteriebetriebenen Elektrofahrzeugen, Photovolatikanlagen und bei Umrichtern. Speziell bei auf minimale Verluste, minimale Induktivität im Leistungskreis, sowie bezüglich der Strom- und Wärmeabfuhr optimierte Leistungsteile von Umrichtern eignet sich die erfindungsgemäße Schaltungsanordnung aufgrund ihrer geringen Bauhöhe.

Die Leistungshalbleiter haben, ausgehend vom eigentlichen Siliziumchip, aufgrund der kompakten Bauweise und Anordnung zwischen den Platten eine nahezu flächige Stromabfuhr und Wärmeabfuhr. Die guten thermischen Eigenschaften der Leistungshalbleiter mit ihrer beidseitig des Siliziumchips kontaktierten Wärmeabfuhr ergibt eine hohe Effektivität der Siliziumfläche bezogen auf die Ausgangsleistung bzw. den Wirkungsgrad eines Systems. Üblicherweise auch durch die Siliziumdicke bedingte Verluste sind drastisch reduziert. Auch der aufwändige mechanische Aufbau zur Herstellung der Druckkontakte gehört der Vergangenheit an. Die Anordnung lässt sich in wenigen Fertigungsschritten automatisiert realisieren und muss bei der Inbetriebnahme lediglich noch in eine dafür vorgesehene Aufnahmevorrichtung eingelegt werden. Dies spart Herstellkosten und Montagekosten.

In einer ersten bevorzugten Ausführungsform ist zwischen der ersten Eingangsleitplatte und der mittleren Ausgangsleitplatte und zwischen der zweiten Eingangsleitplatte und der mittleren Ausgangsleitplatte eine gleiche Anzahl von mehreren Schaltmitteln vorgesehen. Vorzugsweise sind die Schaltmittel zwischen der ersten Eingangsleitplatte und der mittleren Ausgangsleitplatte zueinander parallel geschaltet und gemeinsam ansteuerbar und die Schaltmittel zwischen der zweiten Eingangsleitplatte und der mittleren Ausgangsleitplatte zueinander parallel geschaltet und gemeinsam ansteuerbar. Somit lässt sich eine Halbbrücke realisieren, welche bezüglich der Stromstärke parametrierbar ist, je mehr Schaltmittel parallel geschaltet werden, desto größer wird der mittels der Halbbrücke verarbeitbare Strom, weil sich dieser auf die Schaltmittel verteilt.

In einer zweiten bevorzugten Ausführungsform sind wie bei der ersten bevorzugten Ausführungsform zwischen der ersten Eingangsleitplatte und der mittleren Ausgangsleitplatte und zwischen der zweiten Eingangsleitplatte und der mittleren Ausgangsleitplatte eine gleiche Anzahl von mehreren Schaltmitteln vorgesehen. Um mehrere voneinander separat ansteuerbare Halbbrückenschaltungen zwischen der ersten Eingangsleitplatte und der zweiten Eingangsleitplatte zu realisieren ist jedoch vorgesehen, dass die Halbbrückenschaltungen mittels beider Eingangsleitplatten zwar einen gemeinsamen Eingang aufweisen, jedoch separate Ausgänge aufweisen. Zur Realisierung der separaten Ausgänge ist die mittlere Ausgangsleitplatte entsprechend der Anzahl der Halbbrückenschaltungen mehrteilig ausgebildet, wobei die mehreren Teile zueinander elektrisch isoliert sind und auf gleicher Ebene zwischen beiden Eingangsleitplatten ausgerichtet sind. Somit lässt sich eine Dreiphasen-Wechselrichteranordnung in sehr kompakter Bauform realisieren.

Bevorzug umfasst zumindest die mittlere Ausgangsleitplatte einen Kühlkanal zur Kanalisierung eines Kühlfluids, vorzugsweise eines Kühlwassers, innerhalb der Leitplatte. Mittels der Wasserkühlung kann eine schnellere Wärmeabfuhr bewirkt werden. Speziell die mittlere Platte ist der Wärmeabstrahlung beider Schaltelmittel ausgesetzt. Wird zumindest die mittlere Platte gesteuert gekühlt, so können Hotspots innerhalb der Halbbrückenschaltung vermieden und Wärme gezielt, insbesondere auch gesteuert, abgeführt werden.

Zweckmäßigerweise ist das erste Schaltmittel an einem ersten Bauteilträger und das zweite Schaltmittel an einem zweiten Bauteilträger angeordnet. Die Herstellung und Stabilität der Anordnung wird damit vereinfacht. Als Bauteilträger wird eine IMS-Leiterplatte (IMS: Insulated Metal Substrate) verwendet. Aufgrund der sehr guten Wärmeleitfähigkeit kann in Verbindung mit der Erfindung eine noch weiter verbesserte Wärmeabfuhr erzielt werden.

In einer weiteren Ausführungsform ist von der erfindungsgemäßen Anordnung zumindest ein Ansteuermittel für ein Schaltmittel umfasst und mit dem Steueranschluss des Schaltmittels verbunden. Dies ermöglicht einen kompakten Aufbau einer in sich autark betreibbaren Halbbrückenschaltung, weil die, insbesondere autark arbeitende, Ansteuerung bereits in die Anordnung integriert ist und vorzugsweise an einem Bauteilträger angeordnet ist.

Zweckmäßigerweise ist von der erfindungsgemäßen Anordnung eine Sensorik zur Erfassung der charakteristische Eigenschaften eines Schaltmittels vorgesehen. Dies ermöglicht eine in sich autark betreibbare Halbbrückenschaltung, weil nun auch ein Condition Monitoring realisierbar ist, beispielsweise mittels der zuvor genannten Ansteuerung, mittels welcher auch die Sensorik ansteuerbar und auswertbar ist. Die Sensorik ist vorzugsweise an einem Schaltmittel oder bevorzugt an einem Bautailträger angeordnet.

Weiter zweckmäßig ist auch eine Anschlussmöglichkeit für eine externe Ansteuerung der Schaltmittel vorgesehen, wobei vorzugsweise alternativ eine Anschlussmöglichkeit für eine externe Ansteuerung beider Schaltmittel vorgesehen ist. Die Halbbrückenschaltung kann somit auch von einer übergeordneten Steuereinrichtung angesteuert werden, welche beispielsweise Bestandteil einer Widerstandsschweißeinrichtung oder eines Umrichters sein kann. Vorzugsweise ist eine drahtlose Ansteuermöglichkeit vorgesehen, beispielsweise mittels WLAN, um den Verdrahtungsaufwand zu reduzieren.

Ganz besonders bevorzugt ist ein Schaltmittel in den Bauteilträger engebettet und/oder vorzugsweise vollständig vom Bauteilträger umschlossen, welcher vorzugsweise als flexibler Bauteilträger, vorzugsweise mittels einer Folie realisiert ist. Die Einbettung ermöglichst eine Anordnung mit flacher Bauweise, analog zu einer Scheibenzelle. Je flexibler der Bauuteilträger, desto besser können von der Anordnung selbst mechanische Spannungen intern ausgeglichen werden.

Bevorzugt sind die Schaltmittel als ein MOSFET, vorzugsweise jeweils als ein rückwährtsleitender MOSFET ausgebildet. Durch den Aufbau mit z.B. einem rückwärtsleitenden MOSFET ist es möglich den Freilauf statt über Freilauf-Dioden mit dem Zuschalten des MOSFET zu realisieren. Bauteile können eingespart werden.

Besonders bevorzugt sind die Bereiche zwischen den Leitplatten vergossen, insbesondere mittels eines Kunstharzes. Durch das Vergiessen der inneren Hohlräume kann die Lebensdauer der Gesamtanordnung erhöht werden, denn Umgebungseinflüsse können nicht mehr unmittelbar auf die empfindliche Elektronik einwirken, z.B. Säuren, Schmutz, Feuchtigkeit. Diverse IP-Schutzklassen können somit leicht erfüllt werden. Mittels direktem Sintern der Schaltmittel kann die mögliche Temperaturbelastung bzw. die Lebensdauer ebenfalls verbessert werden. Möglich ist auch neben Löten und Sintern das Verkleben der einzelnen Schaltmittel innerhalb der Anordnung. Der Verguss dient auch als mechanischer Schutz, zur Erhöhung der Lebensdauer der Lötstellen, die durch Temperaturhübe leicht ermüden. Das Vergussmaterial hat einen gleichen thermischen Ausdehnungskoeffizienten wie das umgebende Kupfer, um eine dauerhafte Verbindung mit den Komponenten der Leistungshalbleiter zu gewährleisten und gewährleistet die elektrische Isolation der Komponenten untereinander. Die mechanische Festigkeit wird zur Kontaktpressung der äußeren Platten benötigt, die für die Strom und Wärmeübergänge zwar notwendig sind, allerdings wesentlich geringer als bei drucckontaktiertem Aufbau. Für die Erhöhung der Lebensdauer der Lötstellen wird ein lunkerfreies Umschließen der Lötvolumen gewährleistet.

Eine besonders bevorzugte Anwendung der Erfindung umfasst eine Gleichrichteranordnung gemäß dem unabhängigen Anspruch. Eine weiter bevorzugte Anwendung der Erfindung umfasst eine Wechselrichteranordnung gemäß dem unabhängigen Anspruch. In beiden Anwendungen können die Verluste reduziert werden, so dass der Wirkungsgrad der Anordnungen erhöht werden kann. Die beanspruchte Dreiphasenwechselrichteranordnung hat den Vorteil, dass sie eine dreiphasige Ausgangsspannung bereitstellen kann.

Es versteht sich, dass die vorstehend genannten und die nachfolgend noch zu erläuternden Merkmale nicht nur in der jeweils angegebenen Kombination, sondern auch in anderen, hier nicht explizit genannten Kombinationen, oder in Alleinstellung oder isoliert auftreten können, ohne den Rahmen der vorliegenden Erfindung zu verlassen.

Die Erfindung ist anhand von Ausführungsbeispielen in der Zeichnung schematisch dargestellt und wird im Folgenden unter Bezugnahme auf die Zeichnung ausführlich beschrieben. In den Figuren sind gleiche oder funktionsgleiche Merkmale mit denselben Bezugszeichen versehen, sofern nichts anderes angegeben ist.

### Figurenbeschreibung

Figur 1 zeigt grob schematisch ein erstes Ausführungsbeispiel;
Figur 2 zeigt grob schematisch ein erstes Anwendungsbeispiel dafür;
Figur 3 zeigt grob schematisch ein zweites Ausführungsbeispiel;
Figur 4 zeigt grob schematisch ein zweites Anwendungsbeispiel dafür.

In den Figuren sind gleiche Merkmale mit identischen Bezugszeichen versehen, soweit nichts anderes angegeben ist.

### Detaillierte Beschreibung der Zeichnung

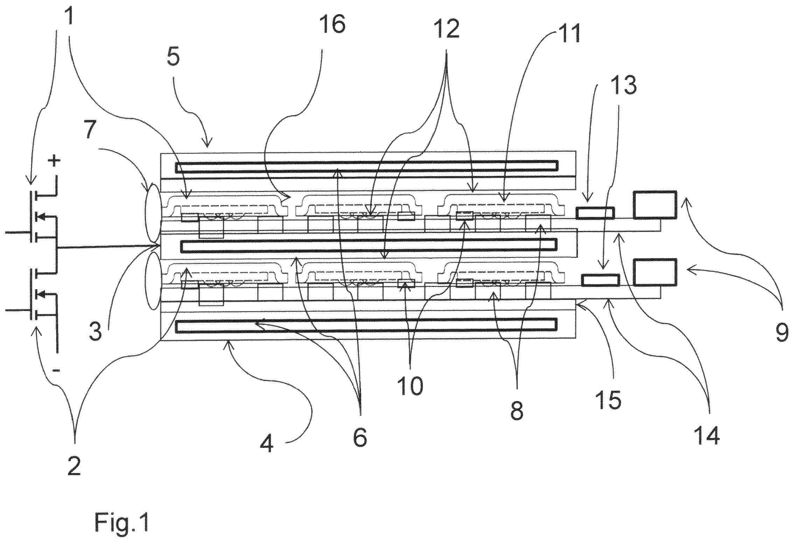

Figur 1 zeigt ein erstes bevorzugtes Ausführungsbeispiel für eine erfindungsgemäßes Leistungshalbbrückengehäuse mit einer Gleichspannung (+/-) am Eingang.

Gezeigt sind Leistungsschalter z.B. MOS-FET 1, 2, eine mittlere Kupferplatte 3 zur Realisierung des Ausgangs der Anordnung, eine erste Eingangs-Kupferplatte 5, eine zweite Eingangs-Kupferplatte 4, eine optionale Wasserkühlung mittels Wärmerohren (Heat-Pipes) oder Kühlplatten 6 aller Kupferplatten 3, 4, 5, vorzugsweise nur der mittleren Kupferplatte 3, eine bevorzugt vorgesehene Randabdeckung 7 des Aufbaus, welche zwischen der ersten und der mittleren Kupferplatte 5, 3 und der mittleren und der zweiten Kupferplatte 3, 4 als Gehäuseabschluss umlaufend vorgesehen ist.

Zwei Leiterplatten 14 (IMS/PCB) mit Leiterbahnen 10 zur Ansteuerung der Leistungsschalter z.B. MOS-FET 1, 2 sind vorgesehen, und bevorzugt zur Verbindung der Steueranschlüsse der Leistungshalbleiter 1, 2 mit einer integrierten Ansteuerung 13 und/oder mit einer Anschlussmöglichkeit (Schnittstelle) 9 für eine externe Ansteuerung (nicht gezeigt). Die Leiterplatten 14 umfassen bevorzugt mehrere Leiterbahnebenen, wobei eine dieser Ebenen bevorzugt auch mit einer der Kupferplatten 3, 4, 5, mittels einer massiven Kupferdurchkontaktierung 8 (Vias oder gefräste oder gepresste Kupferdome) verbunden ist, um einen elektrischen Kontakt zwischen einem Leistungshalbleiteranschluss (z.B. Drain oder Source) und der Kupferplatte 3, 4, 5, herzustellen.

Zwischen den Leiterplatten 14 und den Kupferplatten 3, 4, 5 oder den Leistungsschaltern, z.B. MOS-FET 1, 2, und den Kupferplatten 3, 4, 5 wie im Bild gezeigt sind zusätzliche Kupferplatten (Grundplatte der IMS für die Strom und Wärmeableitung) 15 mit einer IMS (Insulated Metal Substrate) Schicht vorgesehen. IMS oder Insulated Metal Substrate beschreibt die mit einer Leiterplatte fest verbundene Metallplatte. Zur leitenden Verbindung und zur mechanischen Fixierung der Anordnung sind zwischen den Leiterplatten 14 und den Kupferplatten 15 oder den Kupferplatten 3, 4, 5 sowie zwischen den Leistungsschaltern 1, 2 und den Kupferplatten 3, 4, 5 oder den Leiterplatten 14, vorzugsweise wie im Bild gezeigt, Lotschichten 12 oder Sinterschichten 12 vorgesehen.

Folgende Eigenschaften der Anordnung sind vorzugsweise noch vorgesehen:
Die Leistungsschalter 1,2 sind von einem separaten Gehäuse 11 umschlossen, vorzugsweise einem CAN-Gehäuse, wobei die Gehäuse 11, vorzugsweise wie im Bild gezeigt, einer der Platten 3,4,5,15 zugewandt sind und/oder sämtliche Zwischenräume 16 sind mit einer Vergussmasse befüllt, um Thermik, Mechanik und Lebensdauer zu optimieren. Die Spannungsfestigkeit wird durch den Verguss verbessert.
Die erste Kupferplatte 5 kann mit einer positiven Versorgungspannung beaufschlagt werden, die zweite Kupferplatte 4 kann mit einer negativen Versorgungsspannung beaufschlagt werden, die mittlere Kupferplatte 3 stellt aufgrund der Verschaltung der Leistungsschalter 1, 2 nach Art einer Halbbrücke den Halbbrückenausgang dar und liefert im Betrieb ein wechselndes Potenzial zur Realisierung einer Wechselspannung.
Die parallel und in ihrem Randbereich bündig zueinander angeordneten Kupferplatten 3, 4, 5, 15 sind mindestens in ihrem Randbereich mittels eines elektrisch nicht leitfähigen Platten-Verbindungsmittels 7 miteinander verbunden, so dass die Kupferplatten 3, 4, 5 zusammen mit dem Verbindungsmittel 7 ein Halbbrückengehäuse bilden. Das Verbindungsmittel 7 kann eine Vergussmasse sein, es kann alternativ jedoch auch mittels eines Kunststoffes (z.B. Hartkunststoff oder Weichkunststoff) realisiert sein. Besonders vorteilhaft ist die dadurch erzielbare bessere mechanische Festigkeit der Anordnung bei verbesserter Wärmeleitung, geringerer thermischer Dehnung und verbessertem Schutz der Verbindungsstellen und der Leistungsschalter 1, 2.

Mittels des Verbindungsmittels 3 kann eine Anordnung realisiert werden, welche je nach Anwendung auch den für die Verwendung erforderlichen IP-Schutzarten genügt. Bevorzugt ist die Gesamtanordnung bezüglich ihrer Form analog zu einer Scheibenzelle ausgebildet, welche eine runde oder rechteckige Form aufweist. Ein Herausragen der Leiterplatten 14 aus dem Gehäuse, wie im Bild gezeigt, ist nicht zwingend erforderlich. In einer weiter bevorzugten, jedoch nicht abgebildeten, Variante mit allen zuvor erwähnten Merkmalen, ragen die Leiterplatten 14 nicht über die Kupferplatten 3, 4, 5 heraus und schließen mit diesen stattdessen bündig ab. Der optionale Anschluss 9 ist dann bevorzugt an einer geeigneten Stelle der Anordnung angeordnet oder entfällt, beispielsweise wenn eine drahtlose oder integrierte Ansteuermöglichkeit der Anordnung vorgesehen ist.

Bevorzugte Varianten umfassen mehrere Leistungsschalter 1,2 zwischen den Platten, welche zur Erhöhung des steuerbaren Stroms parallel geschaltet sind.

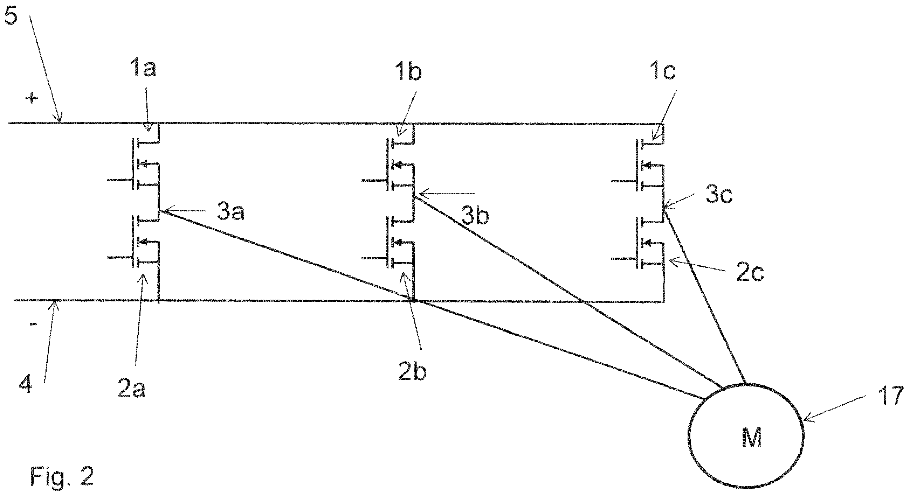

Figur 2 zeigt eine bevorzugte Anwendung einer modifizierten Anordnung gemäß Figur 1. Die Modifikation ist dergestalt, dass eine Dreiphasenhalbbrücke realisiert ist, welche eine erste und eine zweite Kupferplatte 4, 5 als Halbbrückeneingang vorsieht und welche drei voneinander separate mittlere Kupferplatten 3a, 3b, 3c für drei vonenander separate Halbbrückenausgänge zur Realisierung der drei Phasen, beispielsweise zur Ansteuerung eines Motors vorsieht. Für jede Phase ist mindesten ein Paar von Leistungshalbleitern 1, la,2a;lb,2b;lc,2c vorgesehen, wie im Bild gezeigt. Die Anordnung ist kompakt realisiert, wobei die Platten 3a, 3b, 3c, 4, 5 bündig und im Wesentlichen parallel zueinander ausgerichtet sind.

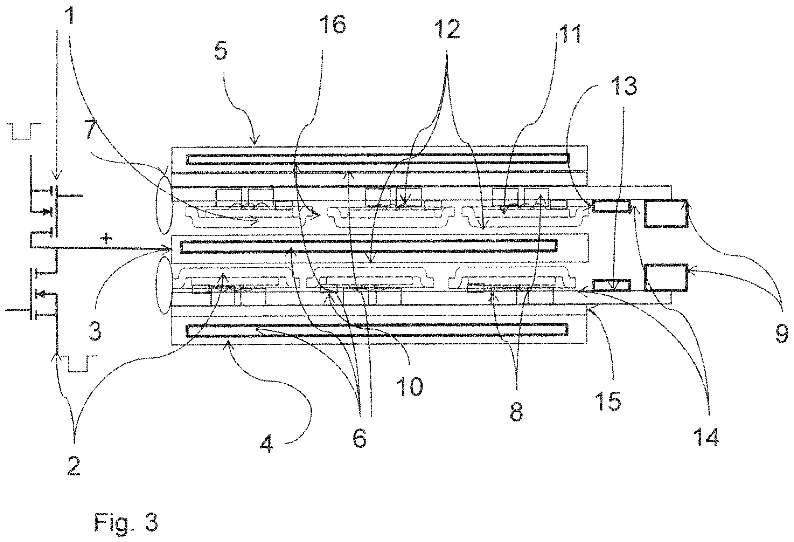

Figur 3 zeigt ein zweites bevorzugtes Ausführungsbeispiel für ein erfindungsgemäßes Leistungshalbbrückengehäuse mit einer pulsierenden Spannung am Eingang.

Gezeigt sind Leistungsschalter z.B. MOS-FET 1, 2, eine mittlere Kupferplatte 3 zur Realisierung des Ausgangs der Anordnung, eine erste Eingangs-Kupferplatte 5, eine zweite Eingangs-Kupferplatte 4, eine optionale Wasserkühlung 6 mittels Wärmerohren (Heat-Pipes) oder Kühlplatten 6 aller Kupferplatten 3, 4, 5, vorzugsweise nur der mittleren Kupferplatte 3, eine bevorzugt vorgesehene Randabdeckung 7 des Aufbaus, welche zwischen der ersten und der mittleren Kupferplatte 5, 3 und der mittleren und der zweiten Kupferplatte 3, 4 als Gehäuseabschluss umlaufend vorgesehen ist.

Zwei Leiterplatten 14 (IMS/PCB) mit Leiterbahnen 10 zur Ansteuerung der Leistungsschalter z.B. MOS-FET 1, 2 sind vorgesehen, und bevorzugt zur Verbindung der Steueranschlüsse der Leistungshalbleiter 1, 2 mit einer integrierten Ansteuerung 13 und/oder mit einer Anschlussmöglichkeit (Schnittstelle) 9 für eine externe Ansteuerung. Die Leiterplatten 14 umfassen bevorzugt mehrere Leiterbahnebenen, wobei eine dieser Ebenen bevorzugt auch mit einer der Kupferplatten 3, 4, 5, verbunden ist, um einen elektrischen Kontakt zwischen einem Leistungshalbleiteranschluss (z.B. Drain oder Source) und der Kupferplatte 3, 4, 5, mittels einer massiven Kupferverbindung 8 herzustellen, bevorzugt sind die Leistungshalbleiteranschlüsse, welche den Ausgang der Halbbrückenschaltung bilden, mit der mittleren Kupferplatte 3 auf diese Art verbunden.

Zwischen den Leiterplatten 14 und den Kupferplatten 3, 4, 5 oder Leistungsschaltern, z.B. MOS-FET 1, 2, und den Kupferplatten 3, 4, 5, wie im Bild gezeigt, sind zusätzliche Kupferplatten (Grundplatte der IMS für die Strom und Wärmeableitung) 15 mit einer IMS (Insulated Metal Substrate) Schicht vorgesehen. IMS oder Insulated Metal Substrate beschreibt die mit einer Leiterplatte fest verbundene Metallplatte. Zur leitenden Verbindung und zur mechanischen Fixierung der Anordnung sind zwischen den Leiterplatten 14 und den Kupferplatten 15 oder den Kupferplatten 3, 4, 5 sowie zwischen den Leistungsschaltern 1, 2 und den Kupferplatten 3, 4, 5 oder den Leiterplatten 14, vorzugsweise wie im Bild gezeigt, Lotschichten 12 oder Sinterschichten 12 vorgesehen.

Folgende Eigenschaften der Anordnung sind vorzugsweise noch vorgesehen:
Eine massive Kupferdurchkontaktierung (Vias oder gefräste oder gepresste Kupferdome) 8 zu einer der Platten 3,4,5 ist vorgesehen und/oder die Leistungsschalter 1,2 sind von einem separaten Gehäuse 11 umschlossen, vorzugsweise einem CAN-Gehäuse, wobei die Gehäuse 11, vorzugsweise wie im Bild gezeigt, einer der Platten 3,4,5,15 zugewandt sind und/oder sämtliche Zwischenräume 16 sind mit einer Vergussmasse befüllt, um Thermik, Mechanik und Lebensdauer zu optimieren. Die Spannungsfestigkeit wird durch den Verguss verbessert.

Die erste Kupferplatte 5 kann mit einer wechselnden Versorgungspannung beaufschlagt werden, die zweite Kupferplatte 4 kann mit einer wechselnden Versorgungsspannung beaufschlagt werden, die mittlere Kupferplatte 3 stellt aufgrund der Verschaltung der Leistungsschalter 1, 2 nach Art einer Halbbrücke den Halbbrückenausgang dar und liefert im Betrieb ein stabiles Potenzial zur Realisierung einer Gleichspannung.

Die parallel und in ihrem Randbereich bündig zueinander angeordneten Kupferplatten 3, 4, 5 sind mindestens in ihrem Randbereich mittels eines elektrisch nicht leitfähigen Platten-Verbindungsmittels 7 miteinander verbunden, so dass die Kupferplatten 3, 4, 5 zusammen mit dem Platten-Verbindungsmittel 7 ein Halbbrückengehäuse bilden. Das Platten-Verbindungsmittel 7 kann eine Vergussmasse sein, es kann alternativ jedoch auch mittels eines Kunststoffes (z.B. Hartkunststoff oder Weichkunststoff) realisiert sein. Besonders vorteilhaft ist die dadurch erzielbare bessere mechanische Festigkeit der Anordnung bei verbesserter Wärmeleitung, geringerer thermischer Dehnung und verbessertem Schutz der Verbindungsstellen und der Leistungsschalter 1, 2.

Mittels des Platten-Verbindungsmittels 7 kann eine Anordnung realisiert werden, welche je nach Anwendung auch den für die Verwendung erforderlichen IP-Schutzarten genügt. Bevorzugt ist die Gesamtanordnung bezüglich ihrer Form analog zu einer Scheibenzelle ausgebildet, welche eine runde oder rechteckige Form aufweist. Ein Herausragen der Leiterplatten 14 aus dem Gehäuse, wie im Bild gezeigt, ist nicht zwingend erforderlich. In einer weiter bevorzugten, jedoch nicht abgebildeten, Variante mit allen zuvor erwähnten Merkmalen, ragen die Leiterplatten 14 nicht über die Kupferplatten 3, 4, 5 heraus und schließen mit diesen stattdessen bündig ab. Der optionale Anschluss 9 ist dann bevorzugt an einer geeigneter Stelle der Anordnung angeordnet oder entfällt, beispielsweise wenn eine drahtlose oder integrierte Ansteuerungsmöglichkeit der Anordnung vorgehsehen ist.

Bevorzugte Varianten umfassen mehrere Leistungsschalter 1,2 zwischen den Platten, welche zur Erhöhung des steuerbaren Stroms parallel geschaltet sind.

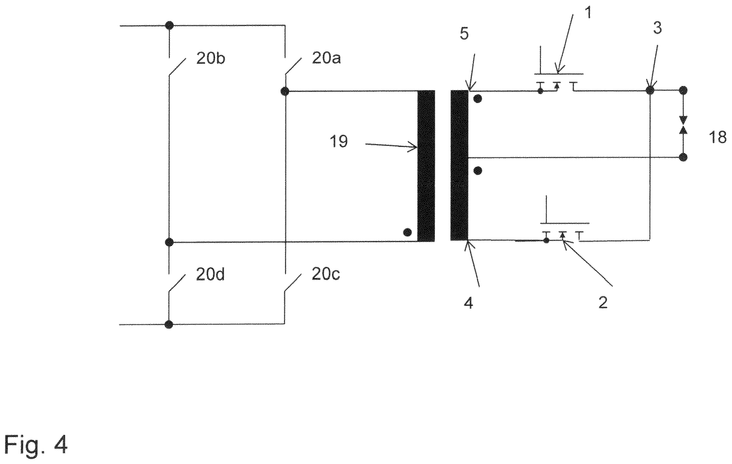

Figur 4 zeigt eine bevorzugte Anwendung eines Leistungshalbleiterbrückengehäuses gemäß Figur 3. Dargestellt ist eine Energieversorgung für eine Widerstandsschweißvorrichtung, umfassend eine Vollbrücke 20a bis 20d zur Bereitstellung einer primärseitigen Wechseleingangsspannung für den ebenfalls umfassten Mittelfrequenzschweißtransformator 19 und ein erfindungsgemäßes Leistungshalbleiterbrückengehäuse mit einer erfindungsgemäßen Halbbrückenschaltung mit Leistungshalbleitern 1,2 zur Bereitstellung eines Widerstandsschweißstromes am Halbbrückenausgang 3, welche eingangsseitig 4,5 von der Sekundärwicklung des Mittelfrequenzschweißtransformators gespeist wird. Vorzugsweise sind der Mittelfrequenztransformator 19 und das Leistungshalbleiterbrückengehäuse separat von der Vollbrücke zu einer baulichen Einheit zusammengefasst, welche an einer Schweißzange anordenbar ist. Die Vollbrücke ist in diesem Falle vorzugsweise von einem Schweißumrichter umfasst, welcher mit der zuvor genannten baulichen Einheit mittels Stromkabel verbunden ist.

### Bezugszeichenliste

- 1, 1a, 1b, 1c: Leistungsschalter z.B. MOS-FET zwischen Eingang 5 und Ausgang 3
- 2, 2a,2b, 2c: Leistungsschalter z.B. MOS-FET zwischen Eingang 4 und Ausgang 3
- 3, 3a, 3b, 3c: Ausgangs-Kupferplatte(n), kann mit einer IMS Ebene verbunden sein
- 4: Eingangs-Kupferplatte, kann mit einer IMS Ebene verbunden sein
- 5: Eingangs-Kupferplatte, kann mit einer IMS Ebene verbunden sein
- 6: Optionale Wasserkühlung der Eingangs- und/oder Ausgangs-Kupferplatten
- 7: Randabdeckung des Aufbaus
- 8: Massive Kupferverbindung zur Grundplatte
- 9: Anschlussstecker für die Ansteuerung der Leistungsschalter
- 10: Leiterbahn auf der IMS/PCB zur Steuerung der Leistungsschalter
- 11: Leistungsschalter im CAN Gehäuse
- 12: Lot oder Sinterschicht optional
- 13: Ansteuerschaltung für den Leistungsschalter
- 14: IMS Schicht bzw. Leiterplatte
- 15: Zusätzliche Kupferplatte mit IMS Schicht
- 16: Auffüllung der Zwischenräume mit Vergussmasse, um Thermik, Mechanik und Lebensdauer zu optimieren
- 17: Elektromotor
- 18: Widerstandsschweiß-Elektroden
- 19: Mittelfrequenz-Schweißtrafo
- 20a-d: IGBTs

## Patentansprüche

1. Halbbrückenschaltungsanordnung für Starkstromanwendungen, insbesondere für Starkstrom-Umrichter oder für Starkstrom-Gleichrichter, umfassend
eine erste Eingangsleitplatte (5) und eine zweite Eingangsleitplatte (4) zur Realisierung des Eingangs der Halbbrückenschaltung sowie eine mittlere Ausgangsleitplatte (3), welche zwischen beiden Eingangsleitplatten (4, 5) und im Wesentlichen parallel zu beiden Eingangsleitplatten (4, 5) angeordnet ist,
ein erstes steuerbares Schaltmittel (1) für Starkstrom mit einem Steueranschluss, welches an einem ersten Bauteilträger (14) sowie zwischen der ersten Eingangsleitplatte (5) und der mittleren Ausgangsleitplatte (3) angeordnet ist,
ein zweites steuerbares Schaltmittel (2) für Starkstrom mit einem Steueranschluss, welches an einem zweiten Bauteilträger (14) sowie zwischen der zweiten Eingangsleitplatte (4) und der mittleren Ausgangsleitplatte (3) angeordnet ist,
wobei beide Schaltmittel (1, 2) mittels der mittleren Ausgangsleitplatte (3) derart miteinander in Serie geschaltet sind, dass ein Ausgang der Halbbrückenschaltung mittels der Ausgangsleitplatte (3) realisiert ist und wobei das erste Schaltmittel **(1)** auch mit der ersten Eingangsleitplatte (5) **und** das zweite Schaltmittel **(2)** auch mit der zweiten Eingangsleitplatte (4) derart verbunden **sind,** dass ein Eingang der Halbbrückenschaltung mittels beider Eingangsleitplatten (4, 5) realisiert ist,
wobei der erste Bauteilträger (14) eine erste Insulated Metal Substrate (IMS) -Leiterplatte **ist, wobei eine zusätzliche Kupferplatte (15) mit einer IMS-Schicht zwischen der ersten IMS-Leiterplatte und der ersten Eingangsleitplatte (5) vorgesehen** ist und das erste Schaltmittel (1) an der ersten **IMS**-Leiterplatte angeordnet ist,
wobei der zweite Bauteilträger (14) eine zweite IMS-Leiterplatte **ist, und wobei eine zusätzliche Kupferplatte (15) mit einer IMS-Schicht zwischen der zweiten IMS-Leiterplatte und der zweiten Eingangsleitplatte (4) vorgesehen** ist und das zweite Schaltmittel (2) an der zweiten **IMS**-Leiterplatte angeordnet ist.

2. Anordnung gemäß Anspruch 1, wobei zwischen der ersten Eingangsleitplatte (5) und der mittleren Ausgangsleitplatte (3) und zwischen der zweiten Eingangsleitplatte (4) und der mittleren Ausgangsleitplatte (3) eine gleiche Anzahl von mehreren Schaltmitteln (1) vorgesehen ist, um mehrere parallele Halbbrückenschaltungen zu realisieren, so dass die Halbbrückenschaltungen mittels beider Eingangsleitplatten (4, 5) einen gemeinsamen Eingang aufweisen und separate Ausgänge aufweisen, wobei zur Realisierung der separaten Ausgänge die mittlere Ausgangsleitplatte (3) entsprechend der Anzahl der Halbbrückenschaltungen mehrteilig ausgebildet ist, wobei die Teile elektrisch isoliert sind.

3. Anordnung gemäß einem der vorhergehenden Ansprüche, wobei zumindest eine der Leitplatten (3, 4, 5), vorzugsweise die mittlere Ausgangsleitplatte (3), einen Kühlkanal (6) zur Kanalisierung eines Kühlfluids, vorzugsweise eines Kühlwassers, innerhalb der Leitplatte (3, 4, 5) umfasst.

4. Anordnung gemäß einem der vorhergehenden Ansprüche,
wobei das erste Schaltmittel (1) an dem ersten Bauteilträger (14) derart angeordnet ist, dass das erste Schaltmittel (1) zwischen der ersten **IMS-**Leiterplatte und der **zusätzlichen Kupferplatte (15)** angeordnet ist, oder
wobei das erste Schaltmittel (1) an dem ersten Bauteilträger (14) derart angeordnet ist, dass das erste Schaltmittel (1) zwischen der ersten **IMS-**Leiterplatte und der mittleren Ausgangsleitplatte (3) angeordnet ist.

5. Anordnung gemäß Anspruch 4, wobei das zweite Schaltmittel (2) an dem zweiten Bauteilträger (14) derart angeordnet ist, dass das zweite Schaltmittel (2) zwischen der zweiten **IMS-**Leiterplatte und der mittleren Ausgangsleitplatte (3) angeordnet ist.

6. Anordnung gemäß einem der vorhergehenden Ansprüche, wobei an dem ersten Bauteilträger (14) auch ein erstes Ansteuermittel (13) für das erste Schaltmittel (1) angeordnet und mit dem Steueranschluss des ersten Schaltmittels (1) verbunden ist, und wobei an dem zweiten Bauteilträger (14) auch ein zweites Ansteuermittel (13) für das zweite Schaltmittel (2) angeordnet ist und mit dem Steueranschluss des zweiten Schaltmittels (2) verbunden ist, wobei vorzugsweise alternativ ein einziges Ansteuermittel für das erste und zweite Schaltmittel (1, 2) vorgesehen und mit den Steueranschlüssen beider Schaltmittel (1, 2) verbunden ist.

7. Anordnung gemäß einem der vorhergehenden Ansprüche, wobei an dem ersten Bauteilträger (14) zusätzlich auch eine Sensorik für das erste Schaltmittel (1) angeordnet ist, so dass charakteristische Eigenschaften des ersten Schaltmittels (1) während des Betriebs der Halbbrückenschaltung erfassbar sind, wobei an dem zweiten Bauteilträger (14) zusätzlich auch eine Sensorik für das zweite Schaltmittel (2) angeordnet ist, so dass charakteristische Eigenschaften des zweiten Schaltmittels (2) während des Betriebs der Halbbrückenschaltung erfassbar sind.

8. Anordnung gemäß einem der vorhergehenden Ansprüche, wobei an dem ersten Bauteilträger (14) zusätzlich auch eine erste Anschlussmöglichkeit (9) für eine externe Ansteuerung des ersten Schaltmittels (1) angeordnet ist und wobei an dem zweiten Bauteilträger (14) zusätzlich auch eine zweite Anschlussmöglichkeit (9) für eine externe Ansteuerung des zweiten Schaltmittels (2) angeordnet ist, wobei vorzugsweise alternativ eine einzige Anschlussmöglichkeit für eine externe Ansteuerung beider Schaltmittel (1, 2) vorgesehen ist.

9. Anordnung gemäß einem der vorhergehenden Ansprüche, wobei beide Schaltmittel (1, 2) jeweils in die Bauteilträger (14) eingebettet sind oder vorzugsweise vollständig vom Bauteilträger umschlossen sind, welcher vorzugsweise als flexibler Bauteilträger (14), vorzugsweise mittels einer Folie realisiert ist.

10. Anordnung gemäß einem der vorhergehenden Ansprüche, wobei das erste Schaltmittel (1) und das zweite Schaltmittel (2) jeweils ein MOSFET ist, vorzugsweise jeweils ein rückwärtsleitender MOSFET.

11. Anordnung gemäß einem der vorhergehenden Ansprüche, wobei die Bereiche zwischen den Leitplatten (3, 4, 5) vergossen sind, vorzugsweise mittels eines Kunstharzes.

12. Anordnung gemäß einem der vorhergehenden Ansprüche,
wobei der Steueranschluss des ersten steuerbaren Schaltmittels (1) derart zwischen der ersten Eingangsleitplatte (5) und der mittleren Ausgangsleitplatte (3) angeordnet ist, dass der Steueranschluss keinen elektrischen Kontakt zu den Platten (3, 5) hat und trotzdem zur Ansteuerung des ersten steuerbaren Schaltmittels (1) noch zwischen den Platten (3, 5) zugänglich bleibt, **und**
wobei der Steueranschluss des zweiten steuerbaren Schaltmittels (2) derart zwischen der zweiten Eingangsleitplatte (4) und der mittleren Ausgangsleitplatte (3) angeordnet ist, dass der Steueranschluss keinen elektrischen Kontakt zu den Platten (3, 4) hat und trotzdem zur Ansteuerung des zweiten steuerbaren Schaltmittels (2) noch zwischen den Platten (3, 4) zugänglich bleibt.

13. Gleichrichteranordnung für eine Widerstandsschweißanlage, realisiert mittels einer Halbbrückenschaltung gemäß einem der vorherigen Ansprüche, wobei am Ausgang der Halbbrückenschaltung Anschlussmittel für Widerstandsschweißelektroden vorgesehen sind und wobei am Eingang der Halbbrückenschaltung Anschlussmittel für eine Eingangswechselspannung vorgesehen sind.

14. Wechselrichteranordnung, vorzugsweise zur Versorgung eines Elektromotors, realisiert mittels einer Halbbrückenschaltung gemäß einem der vorherigen Ansprüche, wobei am Ausgang der Halbbrückenschaltung Anschlussmittel für den Motor vorgesehen sind und wobei am Eingang der Halbbrückenschaltung Anschlussmittel für eine Eingangsgleichspannung vorgesehen ist.

15. Dreiphasenwechselrichteranordnung, eingerichtet, um mittels dreier parallel geschalteter Halbbrückenschaltungen gemäß einem der vorhergehenden Ansprüche, eine dreiphasige, vorzugsweise um im Wesentlichen 120 Grad phasenverschobene, Ausgangsspannung bereitzustellen, wobei die drei Halbbrückenschaltungen mit einer ersten und zweiten gemeinsamen Eingangsleitplatte (4, 5) verbunden sind und mit drei separaten Ausgangsleitplatten (3) verbunden sind, welche zueinander isoliert und zwischen beiden Eingangsleitplatten (4, 5) angeordnet sind.

## Claims

1. Half-bridge circuit arrangement for high current applications, in particular for high current converters or for high current rectifiers, comprising a first input conducting plate (5) and a second input conducting plate (4) for forming the input of the half-bridge circuit, and a central output conducting plate (3) that is arranged between the two input conducting plates (4, 5) and substantially parallel to the two input conducting plates (4, 5),
a first controllable switching means (1) for high current, having a control connection that is arranged on a first component carrier (14) and between the first input conducting plate (5) and the central output conducting plate (3),
a second controllable switching means (2) for high current, having a control connection that is arranged on a second component carrier (14) and between the second input conducting plate (4) and the central output conducting plate (3),
wherein the two switching means (1, 2) are connected in series with one another by means of the central output conducting plate (3) in such a way that an output of the half-bridge circuit is formed by means of the output conducting plate (3), and wherein the first switching means (1) is also connected to the first input conducting plate (5) and the second switching means (2) is also connected to the second input conducting plate (4) in such a way that an input of the half-bridge circuit is formed by means of the two input conducting plates (4, 5),
wherein the first component carrier (14) is a first insulated metal substrate (IMS) printed circuit board, wherein an additional copper plate (15) with an IMS layer is provided between the first IMS printed circuit board and the first input conducting plate (5) and the first switching means (1) is arranged on the first IMS printed circuit board,
wherein the second component carrier (14) is a second IMS printed circuit board, and wherein an additional copper plate (15) with an IMS layer is provided between the second IMS printed circuit board and the second input conducting plate (4) and the second switching means (2) is arranged on the second IMS printed circuit board.

2. Arrangement according to Claim 1, wherein the same number of a plurality of switching means (1) is provided between the first input conducting plate (5) and the central output conducting plate (3) and between the second input conducting plate (4) and the central output conducting plate (3) in order to form a plurality of parallel half-bridge circuits such that the half-bridge circuits have a common input by means of the two input conducting plates (4, 5) and have separate outputs, wherein the central output conducting plate (3) is of multipart design corresponding to the number of half-bridge circuits in order to form the separate outputs, wherein the parts are electrically insulated.

3. Arrangement according to either of the preceding claims, wherein at least one of the conducting plates (3, 4, 5), preferably the central output conducting plate (3), comprises a cooling channel (6) for channelling a cooling fluid, preferably cooling water, within the conducting plate (3, 4, 5).

4. Arrangement according to one of the preceding claims, wherein the first switching means (1) is arranged on the first component carrier (14) in such a way that the first switching means (1) is arranged between the first IMS printed circuit board and the additional copper plate (15), or wherein the first switching means (1) is arranged on the first component carrier (14) in such a way that the first switching means (1) is arranged between the first IMS printed circuit board and the central output conducting plate (3).

5. Arrangement according to Claim 4, wherein the second switching means (2) is arranged on the second component carrier (14) in such a way that the second switching means (2) is arranged between the second IMS printed circuit board and the central output conducting plate (3) .

6. Arrangement according to one of the preceding claims, wherein a first actuating means (13) for the first switching means (1) is also arranged on the first component carrier (14) and is connected to the control connection of the first switching means (1), and wherein a second actuating means (13) for the second switching means (2) is also arranged on the second component carrier (14) and is connected to the control connection of the second switching means (2), wherein a single actuating means for the first and second switching means (1, 2) is preferably alternatively provided and connected to the control connections of the two switching means (1, 2) .

7. Arrangement according to one of the preceding claims, wherein a sensor system for the first switching means (1) is additionally also arranged on the first component carrier (14) such that characteristic properties of the first switching means (1) can be captured during operation of the half-bridge circuit, wherein a sensor system for the second switching means (2) is additionally also arranged on the second component carrier (14) such that characteristic properties of the second switching means (2) can be captured during operation of the half-bridge circuit.

8. Arrangement according to one of the preceding claims, wherein a first connection option (9) for external actuation of the first switching means (1) is additionally also arranged on the first component carrier (14), and wherein a second connection option (9) for external actuation of the second switching means (2) is additionally also arranged on the second component carrier (14), wherein a single connection option for external actuation of the two switching means (1, 2) is preferably alternatively provided.

9. Arrangement according to one of the preceding claims, wherein the two switching means (1, 2) are each embedded in the component carriers (14) or are preferably completely surrounded by the component carrier that is preferably in the form of a flexible component carrier (14), preferably is formed by means of a film.

10. Arrangement according to one of the preceding claims, wherein the first switching means (1) and the second switching means (2) are MOSFETs in each case, preferably reverse-conducting MOSFETs in each case.

11. Arrangement according to one of the preceding claims, wherein the regions between the conducting plates (3, 4, 5) are cast, preferably by means of a synthetic resin.

12. Arrangement according to one of the preceding claims, wherein the control connection of the first controllable switching means (1) is arranged between the first input conducting plate (5) and the central output conducting plate (3) in such a way that the control connection does not have any electrical contact with the plates (3, 5) and in spite of this still remains accessible between the plates (3, 5) to actuate the first controllable switching means (1), and wherein the control connection of the second controllable switching means (2) is arranged between the second input conducting plate (4) and the central output conducting plate (3) in such a way that the control connection does not have any electrical contact with the plates (3, 4) and in spite of this still remains accessible between the plates (3, 4) to actuate the second controllable switching means (2).

13. Rectifier arrangement for a resistance welding system, formed by means of a half-bridge circuit according to one of the preceding claims, wherein connection means for resistance welding electrodes are provided at the output of the half-bridge circuit, and wherein connection means for an input AC voltage are provided at the input of the half-bridge circuit.

14. Inverter arrangement, preferably for supplying an electric motor, formed by means of a half-bridge circuit according to one of the preceding claims, wherein connection means for the motor are provided at the output of the half-bridge circuit, and wherein connection means for an input DC voltage are provided at the input of the half-bridge circuit.

15. Three-phase inverter arrangement configured to provide a three-phase output voltage, which is preferably phase-shifted by substantially 120 degrees, by means of three parallel-connected half-bridge circuits according to one of the preceding claims, wherein the three half-bridge circuits are connected to a first and second common input conducting plate (4, 5) and are connected to three separate output conducting plates (3) that are arranged in a manner insulated from one another and between the two input conducting plates (4, 5).

## Revendications

1. Agencement de circuits en demi-pont pour des applications à courant fort, en particulier des convertisseurs à courant fort ou des redresseurs à courant fort, comprenant
une première plaque conductrice d'entrée (5) et une deuxième plaque conductrice d'entrée (4) pour réaliser l'entrée du circuit en demi-pont, ainsi qu'une plaque conductrice de sortie centrale (3) qui est disposée entre les deux plaques conductrices d'entrée (4, 5) et substantiellement en parallèle aux deux plaques conductrices d'entrée (4, 5),
un premier moyen de commutation (1) pouvant être commandé pour courant fort, doté d'une borne de commande et qui est disposé sur un premier support de composants (14) ainsi qu'entre la première plaque conductrice d'entrée (5) et la plaque conductrice de sortie centrale (3),
un deuxième moyen de commutation (2) pouvant être commandé pour courant fort, doté d'une borne de commande et qui est disposé sur un deuxième support de composants (14) ainsi qu'entre la deuxième plaque conductrice d'entrée (4) et la plaque conductrice de sortie centrale (3),
les deux moyens de commutation (1, 2) étant connectés en série au moyen de la plaque conductrice de sortie centrale (3) de telle sorte qu'une sortie du circuit en demi-pont est réalisée au moyen de la plaque conductrice de sortie (3), et le premier moyen de commutation (1) étant relié également à la première plaque conductrice d'entrée (5) et le deuxième moyen de commutation (2) étant relié également à la deuxième plaque conductrice d'entrée (4) de telle sorte qu'une entrée du circuit en demi-pont est réalisée au moyen des deux plaques conductrices d'entrée (4, 5),
le premier support de composants (14) étant une carte de circuits imprimés à substrat métallique isolé (IMS), une plaque de cuivre (15) supplémentaire dotée d'une couche IMS étant prévue entre la première carte de circuits imprimés IMS et la plaque conductrice d'entrée (5), et le premier moyen de commutation (1) étant disposé sur la première carte de circuits imprimés IMS,
le deuxième support de composants (14) étant une deuxième carte de circuits imprimés IMS, et une plaque de cuivre (15) supplémentaire dotée d'une couche IMS étant prévue entre la deuxième carte de circuits imprimés IMS et la deuxième plaque conductrice d'entrée (4), et le deuxième moyen de commutation (2) étant disposé sur la deuxième carte de circuits imprimés IMS.

2. Agencement selon la revendication 1, dans lequel, entre la première plaque conductrice d'entrée (5) et la plaque conductrice de sortie centrale (3) et entre la deuxième plaque conductrice d'entrée (4) et la plaque conductrice de sortie centrale (3), un même nombre de plusieurs moyens de commutation (1) est prévu pour réaliser plusieurs circuits en demi-pont parallèles de sorte que les circuits en demi-pont présentent au moyen des deux plaques conductrices d'entrée (4, 5) une entrée commune et des sorties séparées, dans lequel, pour réaliser les sorties séparées, la plaque conductrice de sortie centrale (3) est réalisée en plusieurs parties selon le nombre de circuits en demi-pont, les parties étant électriquement isolées.

3. Agencement selon l'une quelconque des revendications précédentes, au moins l'une des plaques conductrices (3, 4, 5), de préférence la plaque conductrice de sortie centrale (3), comprenant un canal de refroidissement (6) pour canaliser un fluide de refroidissement, de préférence de l'eau de refroidissement, à l'intérieur de la plaque conductrice (3, 4, 5).

4. Agencement selon l'une quelconque des revendications précédentes,
le premier moyen de commutation (1) étant disposé sur le premier support de composants (14) de telle sorte que le premier moyen de commutation (1) est disposé entre la première carte de circuits imprimés IMS et la plaque de cuivre (15) supplémentaire, ou
le premier moyen de commutation (1) étant disposé sur le premier support de composants (14) de telle sorte que le premier moyen de commutation (1) est disposé entre la première carte de circuits imprimés IMS et la plaque conductrice de sortie centrale (3).

5. Agencement selon la revendication 4, dans lequel le deuxième moyen de commutation (2) est disposé sur le deuxième support de composants (14) de telle sorte que le deuxième moyen de commutation (2) est disposé entre la deuxième carte de circuits imprimés IMS et la plaque conductrice de sortie centrale (3).

6. Agencement selon l'une quelconque des revendications précédentes, dans lequel, sur le premier support de composants (14), un premier moyen de pilotage (13) pour le premier moyen de commutation (1) est également disposé et relié à la borne de commande du premier moyen de commutation (1), et dans lequel, sur le deuxième support de composants (14), un deuxième moyen de pilotage (13) pour le deuxième moyen de commutation (2) est également disposé et relié à la borne de commande du deuxième moyen de commutation (2), dans lequel de préférence en variante un seul moyen de pilotage est prévu pour le premier et le deuxième moyen de commutation (1, 2) et relié aux bornes de commande des deux moyens de commutation (1, 2).

7. Agencement selon l'une quelconque des revendications précédentes, dans lequel, sur le premier support de composants (14), de plus un système de capteurs pour le premier moyen de commutation (1) est également disposé de sorte que des propriétés caractéristiques du premier moyen de commutation (1) peuvent être détectées pendant le fonctionnement du circuit en demi-pont, dans lequel, sur le deuxième support de composants (14), de plus un système de capteurs pour le deuxième moyen de commutation (2) est également disposé de sorte que des propriétés caractéristiques du deuxième moyen de commutation (2) peuvent être détectées pendant le fonctionnement du circuit en demi-pont.

8. Agencement selon l'une quelconque des revendications précédentes, dans lequel, sur le premier support de composants (14), de plus une première possibilité de connexion (9) pour un pilotage externe du premier moyen de commutation (1) est également disposée, et dans lequel, sur le deuxième support de composants (14), de plus une deuxième possibilité de connexion (9) pour un pilotage externe du deuxième moyen de commutation (2) est également disposée, dans lequel de préférence en variante, une seule possibilité de connexion est prévue pour un pilotage externe des deux moyens de commutation (1, 2).

9. Agencement selon l'une quelconque des revendications précédentes, dans lequel les deux moyens de commutation (1, 2) sont respectivement incorporés dans le support de composants (14) ou sont de préférence entièrement entourés par le support de composants qui est réalisé de préférence sous forme de support de composants (14) flexible, de préférence au moyen d'un film.

10. Agencement selon l'une quelconque des revendications précédentes, dans lequel le premier moyen de commutation (1) et le deuxième moyen de commutation (2) correspondent respectivement à un MOSFET, de préférence respectivement à un MOSFET à conduction inverse.

11. Agencement selon l'une quelconque des revendications précédentes, dans lequel les zones entre les plaques conductrices (3, 4, 5) sont scellées, de préférence au moyen d'une résine synthétique.

12. Agencement selon l'une quelconque des revendications précédentes,
la borne de commande du premier moyen de commutation (1) pouvant être commandé étant disposée entre la première plaque conductrice d'entrée (5) et la plaque conductrice de sortie centrale (3) de telle sorte que la borne de commande ne présente aucun contact électrique avec les plaques (3, 5) et reste malgré tout accessible entre les plaques (3, 5) pour le pilotage du premier moyen de commutation (1) pouvant être commandé, et
la borne de commande du deuxième moyen de commutation (2) pouvant être commandé étant disposée entre la deuxième plaque conductrice d'entrée (4) et la plaque conductrice de sortie centrale (3) de telle sorte que la borne de commande ne présente aucun contact électrique avec les plaques (3, 4) et reste malgré tout accessible entre les plaques (3, 4) pour le pilotage du deuxième moyen de commutation (2) pouvant être commandé.

13. Agencement de redresseurs pour une installation de soudage par résistance, réalisé au moyen d'un circuit en demi-pont selon l'une quelconque des revendications précédentes, des moyens de connexion pour des électrodes de soudage par résistance étant prévus à la sortie du circuit en demi-pont, et des moyens de connexion pour une tension alternative d'entrée étant prévus à l'entrée du circuit en demi-pont.

14. Agencement d'onduleurs, de préférence pour alimenter un moteur électrique, réalisé au moyen d'un circuit en demi-pont selon l'une quelconque des revendications précédentes, des moyens de connexion pour le moteur étant prévus à la sortie du circuit en demi-pont, et des moyens de connexion pour une tension continue d'entrée étant prévus à l'entrée du circuit en demi-pont.

15. Agencement d'onduleurs triphasés, aménagé pour fournir, au moyen de trois circuits en demi-pont selon l'une quelconque des revendications précédentes connectés en parallèle, une tension de sortie triphasée, de préférence substantiellement déphasée de 120 degrés, les trois circuits en demi-pont étant reliés à une première et à une deuxième plaque conductrice d'entrée (4, 5) commune et étant reliés à trois plaques conductrices de sortie (3) séparées qui sont disposées en étant isolées les unes par rapport aux autres et entre les deux plaques conductrices d'entrée (4, 5).
